# EUROPEAN PATENT SPECIFICATION

(11) **EP 4 550 364 B1**
(45) Date of publication and mention of the grant of the patent: **01.07.2026**
(21) Application number: 24825651.3
(22) Date of filing: 23.05.2024
(51) Int. Cl.: H10N 60/01, C23C 14/00, C23C 14/08, C23C 14/30, C23C 14/58, H01B 12/06

(54) **METHOD FOR MANUFACTURING SUPERCONDUCTING WIRE MATERIAL**
VERFAHREN ZUR HERSTELLUNG EINES SUPRALEITENDEN DRAHTMATERIALS
PROCÉDÉ DE FABRICATION DE MATÉRIAU DE FIL SUPRACONDUCTEUR

(30) Priority: 22.06.2023 JP 2023102493
(43) Date of publication of application: 07.05.2025
(73) Proprietor: SUMITOMO ELECTRIC INDUSTRIES, LTD., Osaka-shi, Osaka 541-0041 (JP)
(72) Inventor: NAGAISHI, Tatsuoki, Osaka-shi, Osaka 541-0041 (JP)
(74) Representative: Grünecker Patent- und Rechtsanwälte PartG mbB
(86) International application number: PCT/JP2024/019070
(87) International publication number: WO 2024/262244

(56) References cited:
- EP-A1- 2 474 642
- WO-A1-2018/078876
- JP-A- 2006 232 663
- JP-A- 2012 064 519
- JP-A- 2013 196 768
- JP-A- 2020 107 445
- KR-A- 20210 064 085
- US-A- 6 140 773
- US-A1- 2004 258 851
- US-A1- 2006 182 891
- IIJIMA Y ET AL: "Long length ion-beam-assisted deposition template films for Y-123 coated conductors", PHYSICA C, NORTH-HOLLAND PUBLISHING, AMSTERDAM, NL, vol. 357-360, 23 July 2001 (2001-07-23), pages 952 - 958, XP004274359, ISSN: 0921-4534, DOI: 10.1016/S0921-4534(01)00450-6

## Description

### TECHNICAL FIELD

The present disclosure relates to a method for manufacturing a superconducting wire. The present application claims priority to Japanese Patent Application No. 2023-102493 filed on June 22, 2023.

### BACKGROUND ART

For example, Japanese Patent Laying-Open No. 2012-64519 (PTL 1) discloses a superconducting wire. The superconducting wire disclosed in PTL 1 includes a metal substrate and an buffer layer. The metal substrate includes a main surface. The buffer layer is disposed on the main surface of the metal substrate. Another example of prior art is US2006/0182891A1.

### CITATION LIST

### PATENT LITERATURE

PTL 1: Japanese Patent Laying-Open No. 2012-64519

### SUMMARY OF INVENTION

A method for manufacturing a superconducting wire according to the present disclosure is a method for manufacturing a superconducting wire including a substrate having a main surface, and an buffer layer disposed on the main surface. The method for manufacturing a superconducting wire includes forming the buffer layer on the main surface. The substrate has a width of 15 mm or more in a width direction of the substrate orthogonal to a longitudinal direction of the substrate. The buffer layer includes an IBAD (Ion Beam Assisted Deposition) layer. The IBAD layer is formed by supplying, onto the main surface, a constituent material, being in an evaporated form, of the IBAD layer, while applying an ion beam from an ion beam source onto the main surface, in a state in which the substrate is transported in the longitudinal direction of the substrate. A direction in which the ion beam is applied is inclined with respect to a direction normal to the main surface. A longitudinal direction of the ion beam source is along the width direction of the substrate.

### BRIEF DESCRIPTION OF DRAWINGS

Fig. 1 is a plan view of a superconducting wire 10.
Fig. 2 is a cross-sectional view taken along II-II in Fig. 1.
Fig. 3 is a flowchart of steps for manufacturing superconducting wire 10.
Fig. 4 is a schematic side view illustrating IBAD step S3.
Fig. 5 is a schematic front view illustrating IBAD step S3.
Fig. 6 is a schematic perspective view illustrating a relation between a substrate 11 and an ion beam source 40.

### DETAILED DESCRIPTION

### [Problem to be Solved by the Present Disclosure]

In the superconducting wire disclosed in PTL 1, the buffer layer is formed by an ion beam assisted deposition (IBAD) method. More specifically, an ion beam is applied onto the main surface of the metal substrate, while supplying a constituent material, in an evaporated form, of the buffer layer onto the main surface of the metal substrate, in a state in which the metal substrate is transported in the longitudinal direction of the metal substrate, to thereby form the buffer layer.

In this case, the direction in which the ion beam is applied is inclined with respect to the main surface of the metal substrate. Moreover, the longitudinal direction of an assisted ion source applying the ion beam is along the longitudinal direction of the metal substrate. Therefore, when the superconducting wire disclosed in PTL 1 has a large width, the angle at which the ion beam is applied with respect to the main surface varies depending on the position in the width direction. Consequently, the uniformness in the quality of the buffer layer is impaired.

The present disclosure is made in view of the problem with the conventional technique as set forth above. More specifically, the present disclosure provides a method for manufacturing a superconducting wire improved in uniformity of the quality of the IBAD layer formed by the IBAD method.

### [Advantageous Effect of the Present Disclosure]

With the method for manufacturing a superconducting wire according to the present disclosure, the uniformity of the quality of the IBAD layer can be improved.

### [Description of Embodiments]

Initially, embodiments of the present disclosure are described one by one.

A method for manufacturing a superconducting wire according to an embodiment is a method for manufacturing a superconducting wire including a substrate having a main surface, and a buffer layer disposed on the main surface.

The method for manufacturing a superconducting wire includes forming the buffer layer on the main surface. The substrate has a width of 15 mm or more in a width direction of the substrate orthogonal to a longitudinal direction of the substrate. The buffer layer includes an IBAD layer. The IBAD layer is formed by supplying, onto the main surface, a constituent material, being in an evaporated form, of the IBAD layer, while applying an ion beam from an ion beam source onto the main surface, in a state in which the substrate is transported in the longitudinal direction of the substrate. A direction in which the ion beam is applied is inclined with respect to a direction normal to the main surface. A longitudinal direction of the ion beam source is along the width direction of the substrate.

The method for manufacturing a superconducting wire described above enables improvement in uniformity of the quality of the IBAD layer.

In the method for manufacturing a superconducting wire described above, the substrate may be transported to pass, once or multiple times, in a direction in which the substrate is transported, across a region to which the ion beam is applied.

The method for manufacturing a superconducting wire described above enables improvement in productivity of the superconducting wire, by eliminating the need to move the substrate multiple times around transport mechanisms such as rolls.

In the method for manufacturing a superconducting wire described above, the constituent material, being in the evaporated form, of the IBAD layer may be generated by being evaporated by irradiation with an electron beam, and then supplied onto the main surface.

The method for manufacturing a superconducting wire described above enables improvement in productivity of the superconducting wire, by improvement in the deposition rate of the IBAD layer (by shortening of the time taken to deposit the layer).

In the method for manufacturing a superconducting wire described above, the constituent material of the IBAD layer may be magnesium oxide.

In the method for manufacturing a superconducting wire described above, a constituent material of the substrate may be Hastelloy (registered trademark) or stainless steel.

### [Details of Embodiments of the Disclosure]

Next, details of embodiments of the present disclosure are described with reference to the drawings. In the following drawings, the same or corresponding parts are denoted by the same reference characters, and a description thereof is not herein repeated.

### (Configuration of Superconducting Wire 10)

A configuration of a superconducting wire 10 is described in the following.

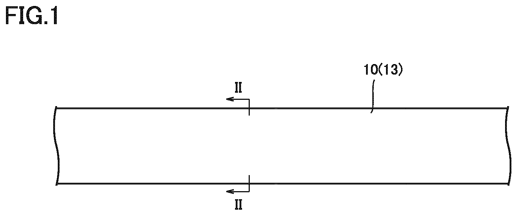

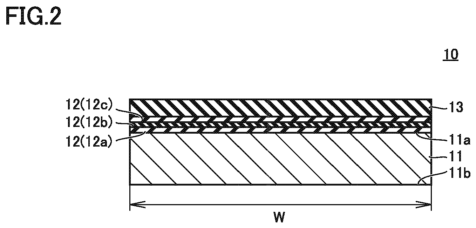

As shown in Figs. 1 and 2, superconducting wire 10 includes a substrate 11, an buffer layer 12, and a superconducting layer 13.

Substrate 11 includes a main surface 11a and a main surface 11b. Main surface 11a and main surface 11b are end faces in the thickness direction of substrate 11. Main surface 11b is a surface opposite to main surface 11a. A constituent material of substrate 11 is, for example, a metal material such as Hastelloy or stainless steel. However, the constituent material of substrate 11 is not limited thereto.

Buffer layer 12 is disposed on substrate 11. Buffer layer 12 is disposed on main surface 11a. Buffer layer 12 includes an underlayer 12a, an IBAD layer 12b, and a surface layer 12c.

Underlayer 12a is disposed on main surface 11a. Underlayer 12a is a layer that prevents diffusion of oxygen and diffusion of constituent elements of substrate 11. Underlayer 12a may be made up of a plurality of layers. Underlayer 12a may be made up of, for example, an amorphous aluminum oxide (Al₂O₃) layer disposed on main surface 11a and an amorphous yttrium oxide (Y₂O₃) layer disposed on the aluminum oxide layer. However, the layer configuration of underlayer 12a is not limited thereto.

IBAD layer 12b is a layer formed by the IBAD method. That is, in IBAD layer 12b, crystals of the constituent material are oriented. IBAD layer 12b is disposed on underlayer 12a. A constituent material of IBAD layer 12b is, for example, magnesium oxide (MgO). However, the constituent material of IBAD layer 12b is not limited thereto.

Surface layer 12c is disposed on IBAD layer 12b. As described above, the crystals of the constituent material are oriented in IBAD layer 12b, and therefore, in surface layer 12c as well, crystals of its constituent material are also oriented. Surface layer 12c is made up of a plurality of layers. Surface layer 12c is made up of, for example, a magnesium oxide layer disposed on IBAD layer 12b and a lanthanum manganite (LaMnO₃) layer disposed on the magnesium oxide layer. Surface layer 12c may be a single layer. In this case, a constituent material of surface layer 12c is, for example, cerium oxide (CeO₂). However, the layer configuration of surface layer 12c is not limited thereto.

Superconducting layer 13 is disposed on buffer layer 12 (surface layer 12c). A constituent material of superconducting layer 13 is an oxide superconductor. Specific examples of the oxide superconductor include REBa₂Cu₃Oₓ. Here, RE is a rare earth element. Examples of the rare earth element include gadolinium (Gd), yttrium (Y), europium (Eu), holmium (Ho), ytterbium (Yb), samarium (Sm), dysprosium (Dy), and neodymium (Nd). However, the rare earth element is not limited thereto. As described above, the crystals of the constituent material are oriented in surface layer 12c, and therefore, in superconducting layer 13 as well, crystals of its constituent material are also oriented. More specifically, in superconducting layer 13, the c-axis of the crystals of the constituent material is oriented in the direction normal to main surface 11a.

The width of substrate 11 is defined as width W. Width W is the width of substrate 11 in the width direction orthogonal to the longitudinal direction of substrate 11. Width W is, for example, 15 mm or more. Width W may be 20 mm or more, 30 mm or more, 50 mm or more, or 100 mm or more. Width W may be, for example, 300 mm or less, 250 mm or less, or 200 mm or less. Width W may be 15 mm or more and 300 mm or less, 15 mm or more and 250 mm or less, or 15 mm or more and 200 mm or less. Width W may be 20 mm or more and 300 mm or less, 20 mm or more and 250 mm or less, or 20 mm or more and 200 mm or less. Width W may be 30 mm or more and 300 mm or less, 30 mm or more and 250 mm or less, or 30 mm or more and 200 mm or less. Width W may be 50 mm or more and 300 mm or less, 50 mm or more and 250 mm or less, or 50 mm or more and 200 mm or less. Width W may be 100 mm or more and 300 mm or less, 100 mm or more and 250 mm or less, or 100 mm or more and 200 mm or less.

### (Method for Manufacturing Superconducting Wire 10)

A method for manufacturing superconducting wire 10 is described in the following.

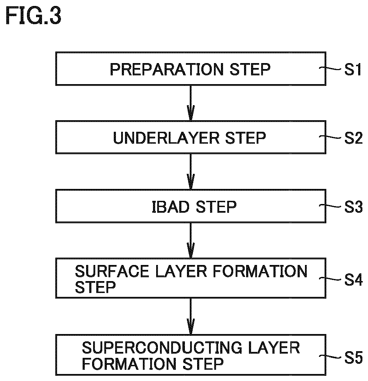

As shown in Fig. 3, the method for manufacturing superconducting wire 10 includes a preparation step S1, an underlayer formation step S2, an IBAD step S3, a surface layer formation step S4, and a superconducting layer formation step S5.

In preparation step S1, substrate 11 is prepared. After preparation step S1, underlayer formation step S2 is performed. In underlayer formation step S2, underlayer 12a is formed on main surface 11a by, for example, magnetron sputtering. After underlayer formation step S2, IBAD step S3 is performed.

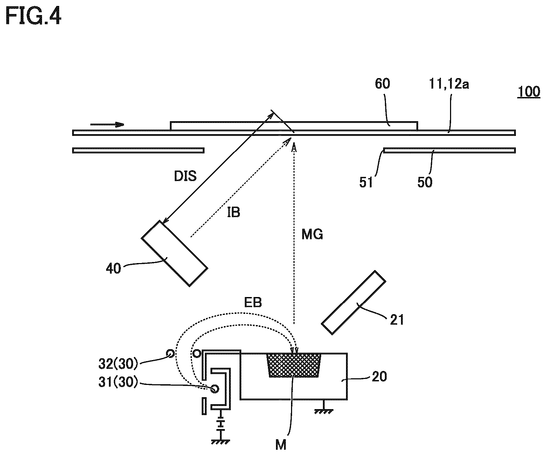

As shown in Figs. 4 to 6, IBAD step S3 is performed using a film deposition apparatus 100. Film deposition apparatus 100 includes a crucible 20, a raw material supply mechanism 21, an evaporation mechanism 30, an ion beam source 40, a shield plate 50, and a heat equalization plate 60. Film deposition apparatus 100 further includes a transport mechanism, which is not shown.

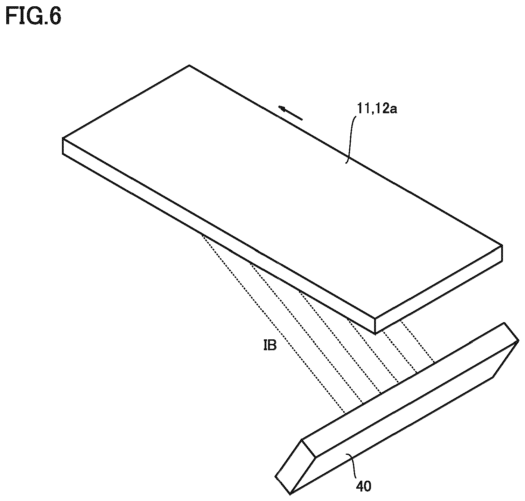

In IBAD step S3, substrate 11 is transported in the longitudinal direction of substrate 11 by the transport mechanism (see black arrows in Fig. 4 and Fig. 6). Substrate 11 is transported over shield plate 50. Main surface 11a (underlayer 12a) faces shield plate 50 with a space therebetween. An opening 51 extending through shield plate 50 in the thickness direction is formed in shield plate 50. For example, substrate 11 is transported so as to pass across a region irradiated with an ion beam IB (described later herein) without turning back, namely, so as to pass across the region irradiated with ion beam IB, only once in the transport direction in which it is transported. That is, substrate 11 is transported in a single-turn manner instead of a multi-turn manner (see Fig. 4 of PTL 1). However, substrate 11 may be transported in the multi-turn manner in which the substrate passes across the region irradiated with ion beam IB, multiple times in the transport direction. Heat equalization plate 60 can be kept at a constant temperature. Heat equalization plate 60 is disposed in contact with main surface 11b located in a portion of substrate 11 that faces opening 51. Thus, the portion of substrate 11 irradiated with ion beam IB (described later herein) is heat-equalized to a constant temperature.

In a state in which substrate 11 is transported, an evaporated raw material MG is supplied onto main surface 11a (underlayer 12a) through opening 51. Evaporated raw material MG is generated by evaporating a raw material M placed in crucible 20 by evaporation mechanism 30. That is, evaporated raw material MG is the constituent material in the evaporated form to constitute IBAD layer 12b. Raw material M is a powder, a granular material, a sintered polycrystalline material, a single crystal, or a crushed material of the constituent material of IBAD layer 12b. Raw material M is supplied from raw material supply mechanism 21 to crucible 20.

Evaporation mechanism 30 includes a filament 31 and a coil 32. Application of a voltage to filament 31 causes electrons to be emitted from filament 31. The electrons emitted from filament 31 are accelerated by a potential difference between filament 31 and crucible 20, and the electrons with their trajectory bent by coil 32 form an electron beam EB. Application of electron beam EB to raw material M causes raw material M to be evaporated into evaporated raw material MG.

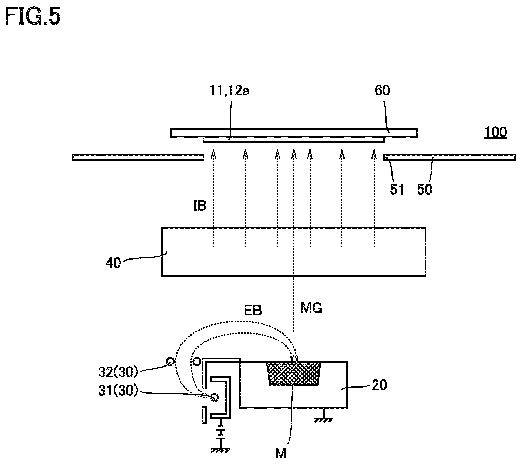

In the state in which substrate 11 is transported, ion beam IB is applied from ion beam source 40 onto main surface 11a (underlayer 12a) through opening 51. Ion beam source 40 has an outlet. The outlet of ion beam source 40 is provided to allow ion beam IB to be emitted uniformly across the entire region in the longitudinal direction of ion beam source 40. As shown in Figs. 4 and 6, the direction in which ion beam IB is applied is inclined with respect to the direction normal to main surface 11a. As shown in Figs. 5 and 6, ion beam source 40 is disposed in such a manner that the longitudinal direction of ion beam source 40 is along the width direction of substrate 11. That is, ion beam source 40 is disposed in such a manner that the longitudinal direction of the outlet of ion beam source 40 is along the width direction of substrate 11. In other words, ion beam source 40 is not arranged with respect to substrate 11 in such a manner that the longitudinal direction of ion beam source 40 is along the longitudinal direction of substrate 11 (see Fig. 4 of PTL 1). The distance between ion beam source 40 and substrate 11 is defined as distance DIS. Distance DIS is, for example, 10 cm or more and 40 cm or less. Distance DIS may be 20 cm or more and 30 cm or less. Evaporated raw material MG is supplied while being irradiated with ion beam IB, so that IBAD layer 12b in which crystals of its constituent material are oriented is grown on main surface 11a (underlayer 12a). After IBAD step S3, surface layer formation step S4 is performed.

In surface layer formation step S4, surface layer 12c is formed on IBAD layer 12b by, for example, magnetron sputtering. After surface layer formation step S4, superconducting layer formation step S5 is performed. In superconducting layer formation step S5, superconducting layer 13 is formed on buffer layer 12 by, for example, MOD (Metal Organic Decomposition) method, PLD (Pulsed Laser Deposition) method, MOCVD (Metal Organic Chemical Vapor Deposition) method, or the like. In this way, the structure of superconducting wire 10 shown in Figs. 1 and 2 is formed.

After superconducting layer formation step S5 is performed, superconducting wire 10 may be slit (cut) into a plurality of superconducting wires in the longitudinal direction of substrate 11. After superconducting layer formation step S5 is performed and before this cutting is performed, a stabilizing layer, which is not shown, may be formed on superconducting layer 13. After the cutting is performed, a protective layer may be formed on the stabilizing layer. The constituent material of the stabilizing layer and the constituent material of the protective layer are, for example, silver (Ag) and copper (Cu), respectively.

In the method for manufacturing superconducting wire 10, substrate 11 having a large width W of 15 mm or more is used. When IBAD layer 12b is formed using substrate 11 having such a large width and the longitudinal direction of ion beam source 40 is along the longitudinal direction of substrate 11, the incident angle of ion beam IB varies depending on the position in the width direction of substrate 11. As a result, the quality of IBAD layer 12b also changes depending on the position in the width direction of substrate 11, and it is difficult to obtain uniform quality of IBAD layer 12b.

In contrast, in the method for manufacturing superconducting wire 10, the longitudinal direction of ion beam source 40 is along the width direction of substrate 11. Therefore, the incident angle of ion beam IB hardly changes depending on the position in the width direction of substrate 11. Accordingly, the method for manufacturing superconducting wire 10 improves the uniformity of the quality of IBAD layer 12b.

In the method for manufacturing superconducting wire 10, substrate 11 is transported to pass across the region irradiated with ion beam IB without turning back, that is, in the single-turn manner. Therefore, the method for manufacturing superconducting wire 10 does not require the step of moving substrate 11 multiple times around transport mechanisms such as rolls, and can form IBAD layer 12b with a large width at a time, so that the productivity of superconducting wire 10 is improved.

In the method for manufacturing superconducting wire 10, evaporated raw material MG is generated by irradiating raw material M with electron beam EB. Therefore, superconducting wire 10 enables the deposition rate of IBAD layer 12b to be improved, as compared with the sputtering method or the like, so that the productivity of superconducting wire 10 is improved.

Regarding ion beam source 40 currently on the market, the smaller the distance DIS, the larger the dimension of the region of ion beam IB in which the intensity falls within a predetermined range, in the longitudinal direction of ion beam source 40. That is, the smaller the distance DIS, the easier the uniformity of the film quality of IBAD layer 12b is ensured. Meanwhile, if distance DIS is too small, the temperature of substrate 11 becomes too high, and the crystals of the constituent material are difficult to be oriented in IBAD layer 12b.

When distance DIS is about 40 cm, it is possible to ensure that the dimension of the region of ion beam IB in which the intensity is within a predetermined range, in the longitudinal direction of ion beam source 40, is about 100 mm. Therefore, in the method for manufacturing superconducting wire 10, distance DIS is set to 10 cm or more and 40 cm or less to thereby enable improvement of the uniformity of the quality of IBAD layer 12b while suppressing deterioration in the degree of orientation of the crystals of the constituent material in IBAD layer 12b.

It should be construed that the embodiments disclosed herein are given by way of illustration in all respects, not by way of limitation. It is intended that the scope of the present invention is defined by claims, not by the above-described embodiments.

### REFERENCE SIGNS LIST

10 superconducting wire; 11 substrate; 11a, 11b main surface; 12 buffer layer; 12a underlayer; 12b IBAD layer; 12c surface layer; 13 superconducting layer; 20 crucible; 21 raw material supply mechanism; 30 evaporation mechanism; 31 filament; 32 coil; 40 ion beam source; 50 shield plate; 51 opening; 60 heat equalization plate; 100 film deposition apparatus; DIS distance; EB electron beam; IB ion beam; M raw material; MG evaporated raw material; S1 preparation step; S2 underlayer formation step; S3 IBAD step; S4 surface layer formation step; S5 superconducting layer formation step; W width.

## Claims

1. A method for manufacturing a superconducting wire comprising:
a substrate (11) including a main surface (11a); and
a buffer layer (12) disposed on the main surface, the method comprising:
forming the buffer layer on the main surface, wherein
the substrate has a width (W) of 15 mm or more in a width direction of the substrate orthogonal to a longitudinal direction of the substrate,
the buffer layer includes an ion beam assisted deposition, IBAD, layer (12b),
the IBAD layer is formed (S3) by supplying, onto the main surface, a constituent material (MG), being in an evaporated form, of the IBAD layer, while applying an ion bean (IB) from an ion beam source (40) onto the main surface, in a state in which the substrate is transported in the longitudinal direction of the substrate,
a direction in which the ion beam is applied is inclined with respect to a direction normal to the main surface, and
a longitudinal direction of the ion beam source is along the width direction of the substrate.

2. The method for manufacturing a superconducting wire according to claim 1, wherein the substrate is transported to pass, once or multiple times, in a direction in which the substrate is transported, across a region to which the ion beam is applied.

3. The method for manufacturing a superconducting wire according to claim 1 or 2, wherein the constituent material, being in the evaporated form, of the IBAD layer is generated by being evaporated by irradiation with an electron beam (EB), and then supplied onto the main surface.

4. The method for manufacturing a superconducting wire according to any one of claims 1 to 3, wherein the constituent material of the IBAD layer is magnesium oxide.

5. The method for manufacturing a superconducting wire according to any one of claims 1 to 4, wherein a constituent material of the substrate is Hastelloy or stainless steel.

## Patentansprüche

1. Verfahren zum Herstellen eines supraleitenden Drahtes, der umfasst:
ein Substrat (11), das einer Hauptfläche (11a) aufweist; sowie
eine Pufferschicht (12), die an der Hauptfläche angeordnet ist, wobei das Verfahren umfasst:
Ausbilden der Pufferschicht auf der Hauptfläche, wobei
das Substrat eine Breite (W) von 15 mm oder mehr in einer Breitenrichtung des Substrats orthogonal zu einer Längsrichtung des Substrats hat,
die Pufferschicht eine IBAD-Schicht (ion beam assisted deposition layer) (12b) einschließt,
die IBAD-Schicht ausgebildet wird (S3), indem in einem Zustand, in dem das Substrat in der Längsrichtung des Substrats transportiert wird, der Hauptfläche ein die IBAD-Schicht bildendes Material (MG) in einer verdampften Form zugeführt wird und gleichzeitig ein Ionenstrahl (IB) von einer Ionenstrahl-Quelle (40) auf die Hauptfläche gerichtet wird,
wobei eine Richtung, in der der Ionenstrahl zum Einsatz kommt, in Bezug auf eine Richtung senkrecht zu der Hauptfläche geneigt ist, und
eine Längsrichtung der Ionenstrahl-Quelle in der Breitenrichtung des Substrats verläuft.

2. Verfahren zum Herstellen eines supraleitenden Drahtes nach Anspruch 1, wobei das Substrat so transportiert wird, dass es einmal oder mehrmals in einer Richtung, in der das Substrat transportiert wird, einen Bereich durchläuft, auf den der Ionenstrahl gerichtet wird.

3. Verfahren zum Herstellen eines supraleitenden Drahtes nach Anspruch 1 oder 2, wobei das die IBAD-Schicht bildende Material in der verdampften Form erzeugt wird, indem es mittels Bestrahlung mit einem Elektronenstrahl (EB) verdampft wird und dann der Hauptfläche zugeführt wird.

4. Verfahren zum Herstellen eines supraleitenden Drahtes nach einem der Ansprüche 1 bis 3, wobei das die IBAD-Schicht bildende Material Magnesiumoxid ist.

5. Verfahren zum Herstellen eines supraleitenden Drahtes nach einem der Ansprüche 1 bis 4, wobei ein das Substrat bildende Material Hastelloy oder rostfreier Stahl ist.

## Revendications

1. Procédé de fabrication d'un fil supraconducteur comprenant :
un substrat (11) incluant une surface principale (11a) ; et
une couche tampon (12) disposée sur la surface principale, le procédé comprenant :
une formation de la couche tampon sur la surface principale, dans lequel le substrat présente une largeur (W) de 15 mm ou plus dans une direction de largeur du substrat orthogonale à une direction longitudinale du substrat,
la couche tampon inclut une couche à dépôt par faisceau d'ions, IBAD, (Ion Beam Assisted Deposition) (12b),
La couche IBAD est constituée (S3) en déposant, sur la surface principale, un matériau constitutif (MG), constitué sous forme évaporée, de la couche IBAD, tout en appliquant un faisceau d'ions (IB, Ion Beam) depuis une source de faisceau d'ions (40) sur la surface principale, dans un état dans lequel le substrat est transporté dans une direction longitudinale du substrat, une direction dans laquelle le faisceau d'ions est appliqué, est inclinée par rapport à une direction normale à la surface principale, et
une direction longitudinale de la source de faisceau d'ions s'axe le long de la direction de largeur du substrat.

2. Le procédé de fabrication d'un fil supraconducteur selon la revendication 1, dans lequel le substrat est transporté pour passer, une fois ou plusieurs, dans une direction dans laquelle le substrat est transporté, à travers une zone à laquelle le faisceau d'ions est appliqué.

3. Le procédé de fabrication d'un fil supraconducteur selon la revendication 1 ou 2, dans lequel le matériau constitutif, constitué sous la forme évaporée, de la couche IBAD est généré en étant évaporé par rayonnement avec un faisceau d'électrons (EB, Electron Beam), puis déposé sur la surface principale.

4. Le procédé de fabrication d'un fil supraconducteur selon l'une quelconque des revendications 1 à 3, dans lequel le matériau constitutif de la couche IBAD est un oxyde de magnésium.

5. Le procédé de fabrication d'un fil supraconducteur selon l'une quelconque des revendications 1 à 4, dans lequel un matériau constitutif du substrat est un Hastelloy ou un acier inoxydable.
